Europäisches Patentamt

European Patent Office

Office européen des brevets

(11) Veröffentlichungsnummer: **0 412 185 A1**

# EUROPÄISCHE PATENTANMELDUNG

(21) Anmeldenummer: 89114736.5

(22) Anmeldetag: 09.08.89

(51) Int. Cl.5: **H01L 29/40**, H01L 21/60, H01L 21/285

(43) Veröffentlichungstag der Anmeldung:
**13.02.91 Patentblatt 91/07**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Willer, Josef, Dr.**
**Friedrich-Fröbel-Strasse 62**
**D-8012 Riemerling(DE)**

(54) **Metallisierung mit Diffusionsbarriere für Halbleiterbauelemente.**

(57) Metallisierung für Halbleiterbauelemente mit einem ersten Anteil (2), einem zweiten Anteil (4) und einem dritten Anteil (5), von denen der erste Anteil (2) einen Kontakt zu Halbleitermaterial (1) bildet, der zweite Anteil (4) eine Diffusionsbarriere aus einer amorphen Wolframlegierung ist und der dritte Anteil (5) das Verbindungsmetall bildet.

## FIG.4

## METALLISIERUNG MIT DIFFUSIONSBARRIERE FÜR HALBLEITERBAUELEMENTE

Zuverlässigkeit und Alterungsfestigkeit von Bauelementen werden ganz entscheidend von der Interdiffusion der Elemente an Kontaktierungen bestimmt. Für Abhilfe sorgen sogenannte Diffusionsbarrieren, die im Idealfall den Atomtransport zwischen zwei Schichten auch bei den höchsten, in einem Fertigungsprozeß auftretenden Temperaturen, völlig unterbinden.

Für die GaAs-Mikroelektronik bedeutet dies die Abtrennung zwischen Ohmkontakt (d. H. der Source- bzw. Drain-Metallisierung) und Schottkykontakt einerseits und dem Verbindungsmetall andererseits. Die Ohmkontakte werden praktisch ausschließlich als Schichtfolgen mit mindestens einer Goldschicht abgeschieden. Bei der Gate-Metallisierung verwendet man z. B. die Schichtfolge Ti/Pt/Au oder Al, sofern es sich um den konventionellen, d. h. den Gate-recess-Prozeß handelt. Als Verbindungsmetall wird häufig ebenfalls Ti/Pt/Au verwendet, obwohl auch Al auch Kostengründen vorteilhaft wäre.

In diesem Zusammenhang treten im wesentlichen zwei Problemstellungen auf: Zum einen muß eine Au-Metallisierung von einer Al-Metallisierung getrennt werden, da sonst die sog. Purpurpest auftritt. Zum anderen ist es für das Alterungsverhalten von Ohmkontakten sehr vorteilhaft, wenn eine Au-Verbindungsmetallisierung nicht als zusätzliche Ga-Senke wirken kann, weil die Ga-Diffusion durch eine Barriere unterbunden wird. Ohne Barriere tritt bei Ohmkontakten im Lauf der Zeit eine Degradation auf, die sich sowohl in einer Aufrauhung der Oberfläche als auch in einer Zunahme des spezifischen Kontaktwiderstands äußert.

Bisher wurde weitgehend auf eine Barriere verzichtet und die Degradation in Kauf genommen. Als mögliche Barrierschichten wurden vorgeschlagen bzw. untersucht: TiN, TiWN, (J. A. Thompson, R. D. Remba (J. Electrochem. Soc., (Dec. 1987), 3205), und Diboride (J. R. Shappirio, J. J. Finnegan, R. A. Lux, J. Vac. Sci. Technol. B4 (1986), 1409). In allen Fällen handelt es sich um polykristalline Schichten, deren Korngrenzen mit Verunreinigungen abgesättigt werden (sog. stuffed barriers). Die Barrierenwirkung ist daher stark vom Abscheideprozeß und den z. T. unabsichtlich mit eingebauten Fremdatomen (z. B. O) abhängig.

In der Veröffentlichung von J. Shappirio, J. Finnegan, R. Lux, D. Fox, J. Kwiatkowski, J. Vac. Sci. Technol. A3(6), 2255 -2258 (1985) ist eine Diffusionsbarriere für ohmische Kontakte auf GaAs angegeben, die zwischen der Kontaktmetallisierung Ni/Ge/Au und einer darüber befindlichen dicken Goldschicht aufgebracht ist. Als Material für diese Diffusionsschicht, die das eindiffundieren des Goldes in die Kontaktschicht verhindern soll, sind $ZrB_2$ und $TiB_2$ gennant.

Aufgabe der vorliegenden Erfindung ist es, eine Metallisierung auf Halbleitermaterial, insbesondere GaAs, anzugeben, bei der auf einfache Weise einerseits ein Eindiffundieren von Verbindungsmetall in eine den eigentlichen Metall-Halbleiter-Kontakt bildende Metallschicht verhindert ist und andererseits ein Ausdiffundieren von Material aus dem Substrat und von chemischen Elementen aus dem Halbleiterkontakt in das Verbindungsmetall vermieden wird.

Diese Aufgabe wird mit der Metallisierung mit den Merkmalen des Anspruches 1 gelöst. Weitere Ausgestaltungen und Merkmale eines besonders vorteilhaften Herstellungsverfahrens einer Metallisierung ergeben sich aus den Unteransprüchen.

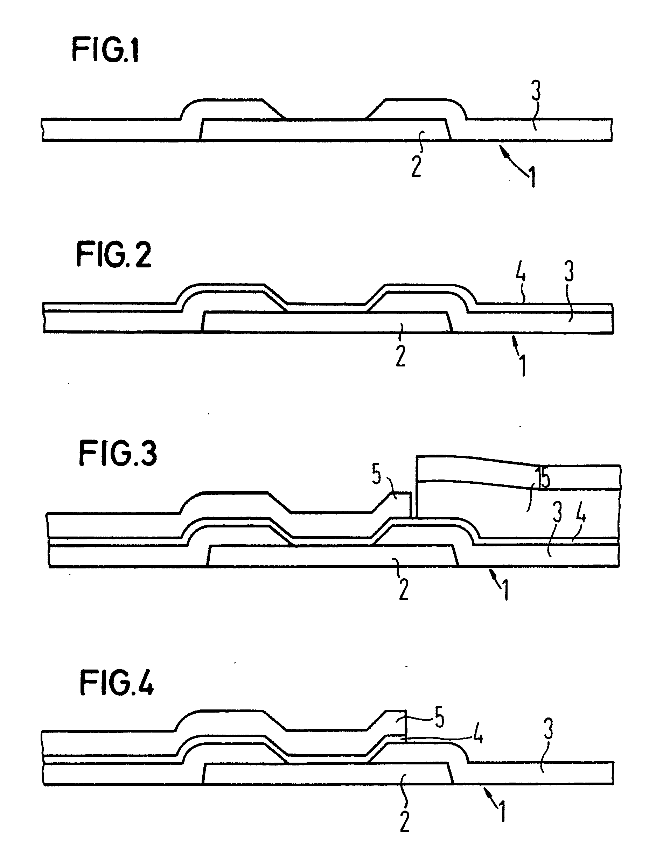

Es folgt eine Beschreibung der erfindungsgemäßen Metallisierung und eines Herstellungsverfahrens anhand der Fig. 1 bis 4, die im Querschnitt vier Prozeßschritte für die Herstellung einer erfindungsgemäßen Metallisierung zeigen.
Fig. 4 zeigt eine Auführungsform der erfindungsgemäßen Metallisierung.

Bei der erfindungsgemäßen Metallisierung wird auf dem Halbleitermaterial 1 (z. B. ein Substrat auf GaAs) eine aus mindestens drei schichtweise übereinander angeordneten Anteilen bestehende Folge verschiedener Metalle bzw. Metallegierungen aufgebracht. Der erste Anteil 2 bildet den eigentlichen Metall-Halbleiter-Kontakt, z. B. einen ohmschen Kontakt oder einen Schottkykontakt. Dieser erste Anteil ist vorzugsweise eine Folge mehrere dünner nacheinander aufgebrachter Metallschichten. Der zweite Anteil 4 bildet die erfindungsgemäße Diffusionsbarriere. Der dritte Anteil 5 stellte das Verbindungsmetall dar und ist in einer vergleichsweise dicken Schicht aufgebracht. Eine Dielektrikumschicht 3 dient der Passivierung. Der besondere Vorteil der erfindungsgemäßen Metallisierung ist darin zu sehen, daß für die Diffusionsbarriere, d. h. den zweiten Anteil 4, eine amorphe Wolframlegierung vorgesehen ist. Wegen der in der Regel relativ niedrigen Kristallisationstemperatur metastabiler amorpher Metalle sind diese bisher nur begrenzt eingesetzt worden. Amorphe Metallschichten haben aber gerade für die Verwendung als Diffusionsbarriere einer Metallisierung den Vorteil, daß sie keine Korngrenzen, die ideale Diffusionskanäle bilden würden, aufweisen.

Unter einer Wolframlegierung im erfindungsgemäßen Sinne sind alle Verbindungen, Legierungen, Mischungen und Mischungen von Verbindungen von Wolfram mit einem anderen chemischen Stoff zu verstehen. Vorzugsweise kommt $WB_x$ zur An-

wendung. Die amorphe Phase tritt bei den Übergangsmetall-Metalloid-Legierungen im Bereich der eutektischen Konzentration auf. Da diese Legierungen sehr hohe Kristallisationstemperaturen aufweisen (bei WSi mit 32 Atomprozenten Si liegt die Kristallisationstemperatur oberhalb 800 °C) eignen sie sich vorzüglich als Diffusionsbarrieren.

Die Kristallisationstemperatur amorpher Metalle hängt im allgemeinen von der Konzentration ab. Das Maximum tritt in der Regel nahe der eutektischen Zusammensetzung auf. Für die erfindungsgemäße Anwendung als Diffusionsbarriere soll daher die Konzentration vorzugsweise in einem Bereich um diese eutektische Zusammensetzung liegen. Besonders vorteilhaft ist eine Zusammensetzung, bei der das mit dem Wolfram legierte Material in einem Bereich von 10 Atomprozenten über oder unter dem Eutektikum liegt. Im Falle des Si liegt eine eutektische Zusammensetzung bei einer Legierung mit 32 Atomprozenten Si vor; im Falle des B liegt eine eutektische Zusammensetzung bei einer Legierung mit 27 Atomprozenten Bor vor. Der Anteil an Si in der Zusammensetzung mit Wolfram sollte also vorteilhaft zwischen 22 und 42 Atomprozenten liegen, der Anteil des B entsprechend zwischen 17 und 37 Atomprozenten.

Die Wirkung einer Wolframborid-Diffusionsbarriere ist anhand der Auger-Tiefenprofile im ungetemperten bzw. bei 400 °C getemperten Zustand überprüft worden. Der Schichtaufbau der Metallisierung auf einem GaAs-Substrat setzte sich aus einem einen ohmschen Kontakt bildenden ersten Anteil aus Ge/Au/Ni/Au, einem zweiten Anteil aus Wolframborid als Diffusionsbarriere und einer Aluminium-Deckschicht zusammen. Dabei war weder eine Gold-Aluminium-Interdiffusion noch eine Ausdiffusion chemischer Elemente aus dem Substrat feststellbar. Die gleiche Sperrwirkung wurde auch an Schichtaufbauten gefunden, die an Stelle von Aluminium eine Ti/Pt/Au-Schichtfolge als dritten Anteil aufwies.

Das Herstellungsverfahren für eine spezielle Ausführungsform der erfindungsgemäßen Metallisierung ist in verschiedenen Schritten in den Fig. 1 bis 4 dargestellt. Auf die Oberfläche eines Halbleitermateriales 1 (z. B. GaAs-Substrat) ist ein erster Anteil 2 der Metallisierung in einer strukturierten Form als ohmscher Kontakt oder Schottkykontakt aufgebracht. Darauf wird eine Dielektrikumschicht 3 aufgebracht, die auf der Oberfläche des ersten Anteils 2 eine diese Oberfläche freigebende Öffnung aufweise (Fig. 1). Auf diese Struktur wird ganzflächig Wolframborid (mit z. B. 27 Atomprozenten Bor) aufgesputtert (Dicke dieses zweiten Anteiles 4 typisch 100 nm). Damit ist die Struktur nach Fig. 2 hergestellt. Mit Hilfe einer Lackmaske 15 (Fig. 3) wird in Abhebetechnik das Verbindungsmetall als dritten Anteil 5 aus z. B. Aluminium oder Ti/Pt/Au aufgedampft und der auf der Lackmaske 15 befindliche Anteil abgehoben. Das Verbindungsmetall dient als Ätzmaske für das reaktive Ionenätzen des Wolframborids des zweiten Anteils 4. Damit wird die in Fig. 4 dargestellte Struktur hergestellt, die gegebenenfalls passiviert werden kann. Alternativ zu diesem Herstellungsverfahren ist es möglich, den dritten Anteil 5 ganzflächig abzuscheiden und eine Strukturierung des zweiten Anteiles 4 und des dritten Anteiles 5 gegebenenfalls mittels Maskentechnik vorzunehmen.

## Ansprüche

1. Metallisierung für Halbleiterbauelemente mit mindestens drei in Lagen übereinander aufgebrachten Anteilen, von denen der erste Anteil (2) einen Kontakt zu Halbleitermaterial bildet, von denen der zweite Anteil (4) eine Diffusionsbarriere zwischen dem ersten Anteil (2) und dem dritten Anteil (5) bildet und von denen der dritte Anteil (5) ein für elektrischen Anschluß vorgesehenes Verbindungsmetall bildet, **dadurch gekennzeichnet,** daß der zweite Anteil (4) eine amorphe Wolframlegierung ist.

2. Metallisierung nach Anspruch 1, **dadurch gekennzeichnet,** daß der zweite Anteil (4) eine amorphe Wolframboridlegierung ist.

3. Metallisierung nach Anspruch 1 oder 2, **dadurch gekennzeichnet,** daß sich die amorphe Wolframlegierung um maximal 10 Atomprozente des mit dem Wolfram legierten Materials von einer eutektischen Zusammensetzung unterscheidet.

4. Metallisierung nach Anspruch 2, **dadurch gekennzeichnet,** daß die Wolframboridlegierung zwischen 17 und 37 Atomprozente Bor enthält.

5. Metallisierung nach Anspruch 2, **dadurch gekennzeichnet,** daß die Wolframboridlegierung zwischen 21 und 33 Atomprozente Bor enthält.

6. Metallisierung nach Anspruch 1, **dadurch gekennzeichnet,** daß die Wolframlegierung eine Wolframsiliziumlegierung ist und daß diese Wolframsiliziumlegierung zwischen 22 und 42 Atomprozente Silizium enthält.

7. Metallisierung nach Anspruch 2, 4 oder 5, **dadurch gekennzeichnet,** daß der erste Anteil (2) auf GaAs aufgebracht ist und die Schichtfolge Ge/Au/Ni/Au aufweist und daß der dritte Anteil (5) Al ist.

8. Verfahren zur Herstellung einer Metallisierung nach Anspruch 1, bei dem in einem ersten Schritt der erste Anteil (2) aufgebracht wird,

**dadurch gekennzeichnet,**
daß in einem zweiten Schritt eine Dielektrikumschicht (3) mit einer die Oberfläche des ersten Anteils (2) freilassenden Öffnung aufgebracht wird,
daß in einem dritten Schritt der zweite Anteil (7) aufgebracht wird,
daß in einem vierten Schritt mittels Masken- und Abhebetechnik der dritte Anteil (5) strukturiert aufgebracht wird und
daß in einem fünften Schritt der zweite Anteil (4) im Bereich außerhalb des dritten Anteils (5) rückgeätzt wird.

9. Verfahren zur Herstellung einer Metallisierung nach Anspruch 1, bei dem in einem ersten Schritt der erste Anteil (2) aufgebracht wird,
**dadurch gekennzeichnet,**
daß in einem zweiten Schritt eine Dielektrikumschicht (3) mit einer die Oberfläche des ersten Anteils (2) freilassenden Öffnung aufgebracht wird,
daß in einem dritten Schritt der zweite Anteil (4) aufgebracht wird,
daß in einem vierten Schritt der dritte Anteil (5) aufgebracht wird und
daß in einem fünften Schritt der zweite Anteil (4) und der dritte Anteil (5) mittels Maskentechnik strukturiert werden.

FIG.1

FIG.2

FIG.3

FIG.4

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | SOLID STATE TECHNOLOGY, Band 26, Nr. 12, Dezember 1983, Seiten 129-133, Port Washington, New York, US; M.-A. NICOLET et al.: "Amorphous metallic alloys in semiconductor contact metallizations" * Figur 1 * | 1 | H 01 L 29/40 H 01 L 21/60 H 01 L 21/285 |
| A | * Tabelle 1 * | 6 | |
| A | EP-A-0 303 079 (SIEMENS AG) * Spalte 4, Zeilen 32-46 * | 2-5 | |
| A | I.E.E.E. ELECTRON DEVICE LETTERS, Band 9, Nr. 8, August 1988, Seiten 405-407, IEEE, New York, NY, US; T. WON et al.: "A high-gain GaAs/AlGaAs n-p-n heterojunction bipolar transistor on (100) Si grown by molecular beam epitaxy" * Seite 405, Spalte 2, Zeilen 23-25 * | 7 | |
| A | EP-A-0 295 065 (HITACHI) * Figuren 9p(a-d); Seiten 27, Spalten 51-62 * | 8,9 | RECHERCHIERTE SACHGEBIETE (Int. Cl.5) H 01 L |

Der vorliegende Recherchenbericht wurde für alle Patentansprüche erstellt

| Recherchenort | Abschlußdatum der Recherche | Prüfer |
|---|---|---|
| DEN HAAG | 17-04-1990 | NILES N.P.E. |

EPO FORM 1503 03.82 (P0403)